# EUROPEAN PATENT APPLICATION

(11) **EP 4 621 935 A1**
(43) Date of publication of application: **24.09.2025**
(21) Application number: 25162049.8
(22) Date of filing: 06.03.2025
(51) Int. Cl.: H01M 10/48, H01M 50/209, H01M 50/507, H01M 50/519, H01M 50/569

(54) **BUSBAR HOLDER AND BATTERY MODULE**

(30) Priority: 19.03.2024 KR 20240037768
(71) Applicant: SAMSUNG SDI CO., LTD., Yongin-si, Gyeonggi-do 17084 (KR)
(72) Inventor: PARK, KYUNG HOON, 16678 Suwon-si, Gyeonggi-do (KR)
(74) Representative: Gulde & Partner

(57) **Abstract**

A busbar holder and a battery module are disclosed. A busbar holder includes a holder plate which supports a plurality of busbars electrically connecting a plurality of battery cells and a length adjuster supported by the holder plate and supporting a flexible circuit part configured to transmit an electric signal generated by measuring a state of the battery cells such that the flexible circuit part extends along a bent path.

## Description

### BACKGROUND

### 1. Field

Aspects of embodiments of the present disclosure relate to a busbar holder and a battery module.

### 2. Discussion of Related Art

Generally, as the demand for portable electronic products, such as notebook computers, video cameras, and portable phones, increases rapidly, and commercialization of robots, electric vehicles, and the like begins in earnest, research on high-performance secondary batteries capable of repeated charging and discharging is being actively conducted.

Secondary batteries are widely used for driving devices or energy storage in not only small devices such as portable electronic devices, but also in medium-to-large devices, such as electric vehicles and energy storage systems (ESSs). Particularly, in the case of medium-to-large devices, a battery module may be formed in a form in which a plurality of battery cells are electrically connected to each other in order to increase an output power and capacity of the battery.

A battery module may include sensors, such as temperature sensors and voltage sensors, for detecting a state of the battery module during charging or discharging. However, battery cells may expand while the battery module is charged or discharged, and, thus, original locations of the sensors may change. When the locations of the sensors change, the sensors may be electrically disconnected from a flexible printed circuit (FPC). When the sensors are electrically disconnected from the FPC, the state of the battery module cannot be checked.

The aforementioned information disclosed in this background section is provided for enhancement of understanding of the background technology of the present disclosure, and therefore may contain information that does not constitute the related art.

### SUMMARY

According to an aspect of embodiments of the present disclosure, a busbar holder which supports a flexible circuit part such that a sensing part is not electrically disconnected from the flexible circuit part, even when a battery cell expands, and a battery module are provided.

However, aspects and objectives to be achieved by the present disclosure are not limited to the above-described aspects and objectives, and other aspects and objectives, which are not described above, will be clearly understood by those skilled in the art through the following description of the present disclosure.

According to one or more embodiments, a busbar holder includes a holder plate which supports a plurality of busbars electrically connecting a plurality of battery cells, and a length adjuster supported by the holder plate and supporting a flexible circuit part configured to transmit an electric signal generated by measuring a state of the battery cells, such that the flexible circuit part extends along a bent path.

The length adjuster may support the flexible circuit part such that a length of a bent section of the flexible circuit part decreases when a volume of the battery cells expands.

The length adjuster may include a bent path part including a first roller and a second roller arranged to support the flexible circuit part and spaced apart from each other such that the flexible circuit part extends along a zigzag path, and a first elastic member which elastically presses the first roller in a direction in which the first roller is moved away from the second roller.

The bent path part may include a plurality of bent path parts, and the length adjuster may further include a tension adjuster including a tension roller which is located between a pair of bent path parts spaced apart from each other among the plurality of bent path parts, is in contact with the flexible circuit part, and is movable by tension of the flexible circuit part.

The tension adjuster may further include a tension roller bracket which supports the tension roller to allow the tension roller to be position-moved and an elastic tension roller pressing member which elastically presses the tension roller in an increase direction of the tension of the flexible circuit part.

The busbar holder may further include a temperature sensor through portion for a temperature sensor to measure a temperature of the plurality of battery cells to pass through the holder plate. In other words, the busbar holder may include an opening which may be traversed by a temperature sensor or by parts of a temperature sensor.

According to one or more embodiments, a battery module includes a plurality of battery cells, a sensing part to measure a state of the battery cells, a flexible circuit part to transmit an electric signal generated by the sensing part, and a length adjuster which supports the flexible circuit part such that the flexible circuit part extends along a bent path.

The length adjuster may support the flexible circuit part such that a length of a bent section of the flexible circuit part decreases when a volume of the battery cells increases.

The length adjuster may include a bent path part including a first roller and a second roller arranged to support the flexible circuit part and spaced apart from each other such that the flexible circuit part extends along a zigzag path, and a first elastic member which elastically presses the first roller in a direction in which the first roller is moved away from the second roller.

The bent path part may further include a roller bracket which supports the first roller to allow the first roller to be position-moved.

The bent path part may further include a second elastic member elastically supporting the second roller in a direction in which the second roller is moved away from the first roller, and the roller bracket may support the second roller to allow the second roller to be position-moved (or moved, or moved such, that a position of the second roller is changed).

The bent path part may include a plurality of bent path parts, and the length adjustment unit may further include a tension adjuster including a tension roller which is located between a pair of bent path parts spaced apart from each other among the plurality of bent path parts, is in contact with the flexible circuit part, and is movable by tension of the flexible circuit part.

The tension adjuster may further include a tension roller bracket which supports the tension roller to allow the tension roller to be position-moved (or moved, or moved such, that a position of the tension roller is changed), and an elastic tension roller pressing member which elastically presses the tension roller in an increase direction of the tension of the flexible circuit part.

The plurality of battery cells may be arranged in a first direction, the flexible circuit part may include a main circuit part extending to be parallel to the first direction, and a sub-circuit part connecting the sensing part and the main circuit part, and the length adjuster may support the main circuit part.

The battery module may further include a plurality of busbars electrically connecting the plurality of battery cells and a busbar holder supporting the plurality of busbars, and the busbar holder may include the length adjuster.

### BRIEF DESCRIPTION OF THE DRAWINGS

The following drawings attached to this specification illustrate some embodiments of the present disclosure, and further describe aspects and features of the present disclosure together with the detailed description of the present disclosure. However, the present disclosure should not be construed as being limited to the drawings.
FIG. 1 is a perspective view illustrating a battery module according to an embodiment of the present disclosure;
FIG. 2 is a top exploded perspective view illustrating the battery module of FIG. 1;
FIG. 3 is a bottom exploded perspective view illustrating the battery module of FIG. 1;
FIG. 4 is a top perspective view illustrating a busbar holder, a busbar, and a flexible printed circuit (FPC) shown in FIG. 2;
FIG. 5 is a bottom perspective view illustrating the busbar holder, the busbar, and the FPC shown in FIG. 2;
FIG. 6 is a plan view illustrating the busbar holder, the busbar, and the FPC shown in FIG. 2;
FIG. 7 is a plan view illustrating the busbar holder shown in FIG. 2;
FIG. 8 is an enlarged perspective view illustrating a region "A" of FIG. 6 from a side;
FIG. 9 is an enlarged perspective view illustrating the region "A" of FIG. 6 from another side;
FIG. 10 is an enlarged plan view illustrating the region "A" of FIG. 6;
FIG. 11 is a cross-sectional view along the line B-B of FIG. 10; and
FIG. 12 is a view corresponding to the cross-sectional view of FIG. 11 and illustrating a state in which a plurality of battery cells of the battery module have expanded.

### DETAILED DESCRIPTION

Herein, some embodiments of the present disclosure will be described, in further detail, with reference to the accompanying drawings. The terms or words used in this specification and claims are not to be construed as being limited to the usual or dictionary meaning and are to be interpreted as having meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not necessarily represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer, or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element, or the first element may be indirectly coupled or connected to the second element via one or more intervening elements.

In the figures, dimensions of the various elements, layers, etc. may be exaggerated for clarity of illustration. The same reference numerals designate the same or like elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections are not to be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all sub-ranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are the same or substantially the same. Thus, the phrase "the same" or "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being arranged (or located or positioned) on the "above (or below)" or "on (or under)" a component, it may mean that the arbitrary element is placed in contact with the upper (or lower) surface of the component and may also mean that another component may be interposed between the component and any arbitrary element arranged (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part may be directly electrically connected to another part, or one or more intervening parts may be present therebetween such that the part and the another part are indirectly electrically connected to each other.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

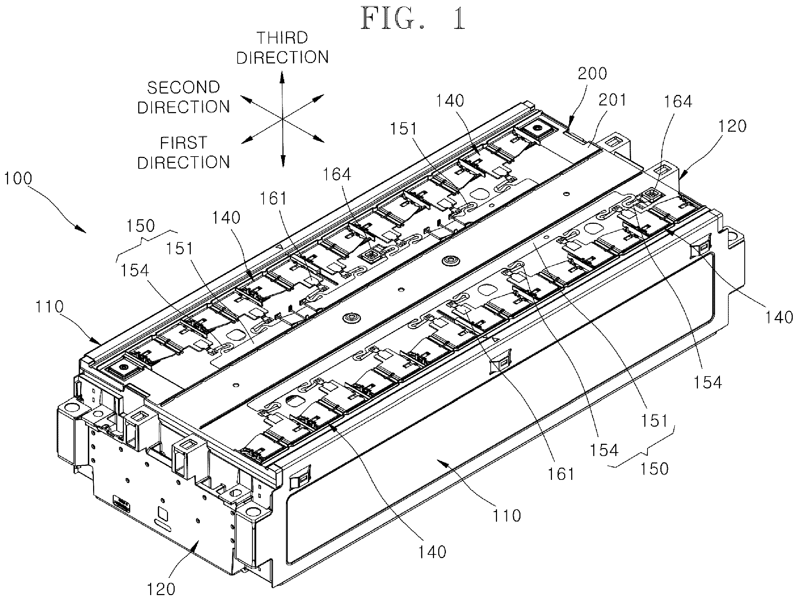

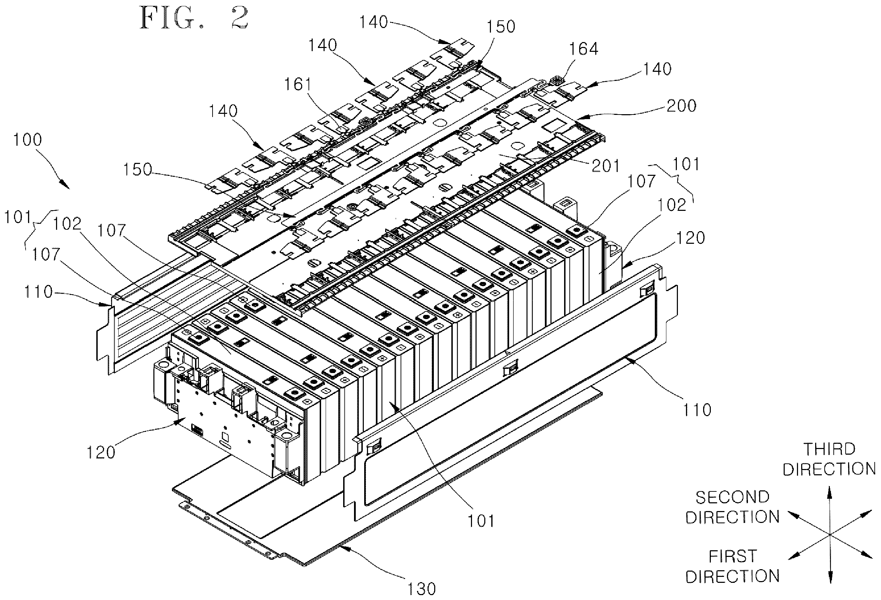

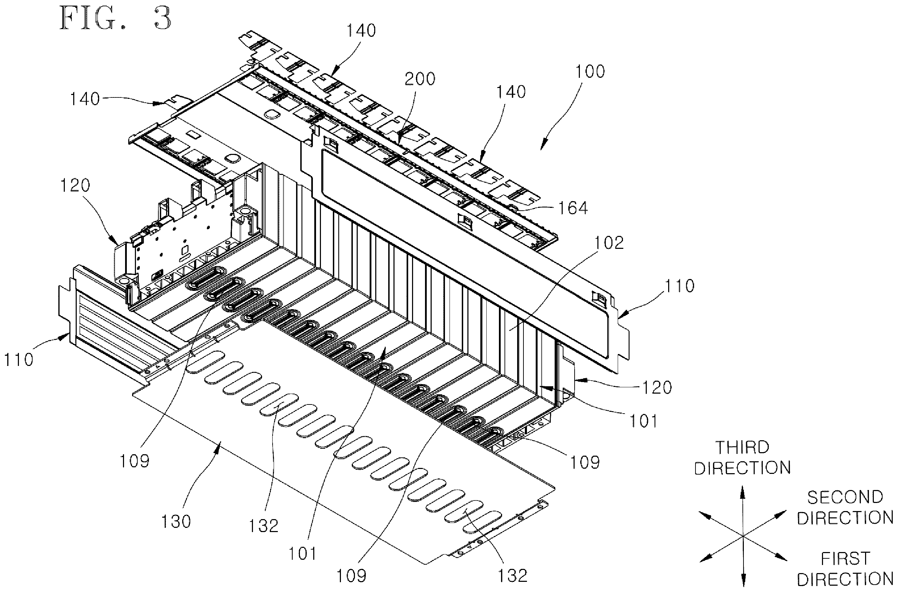

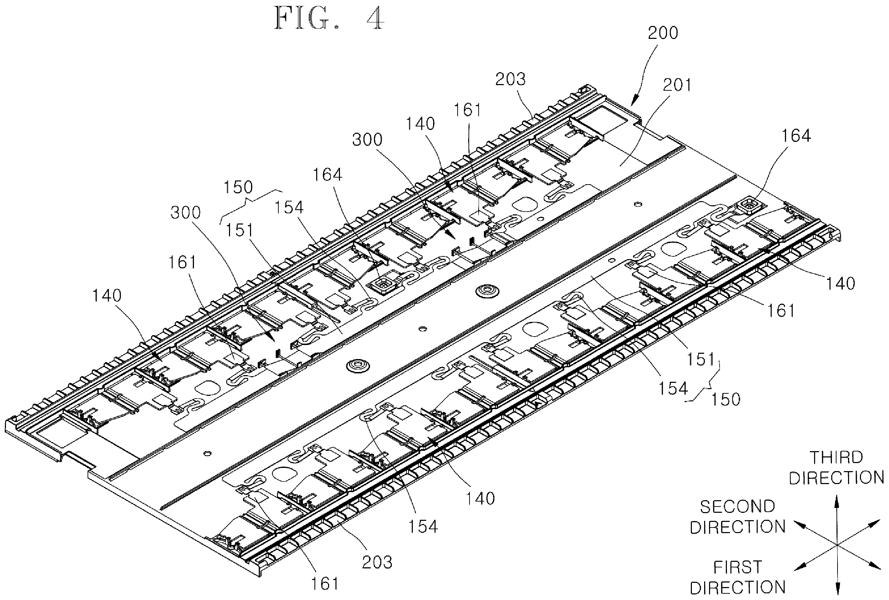

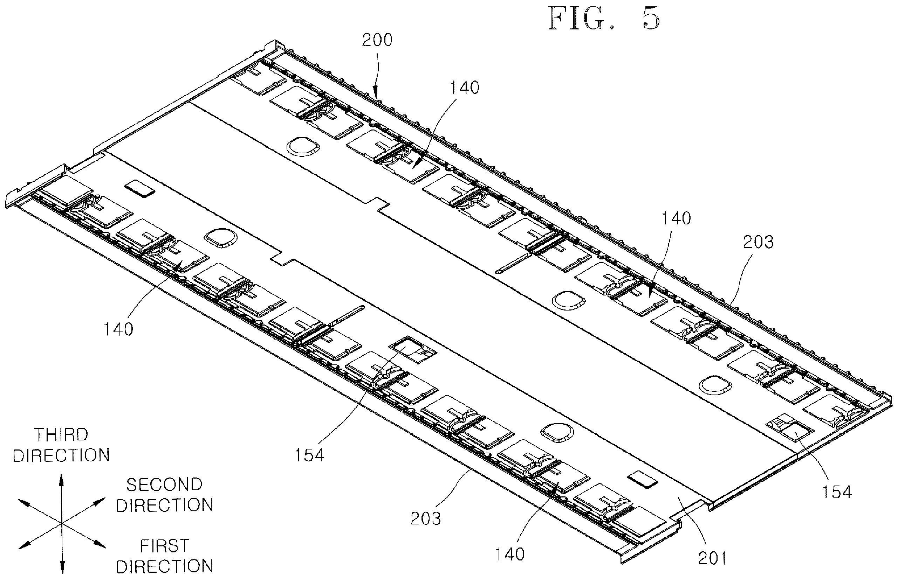

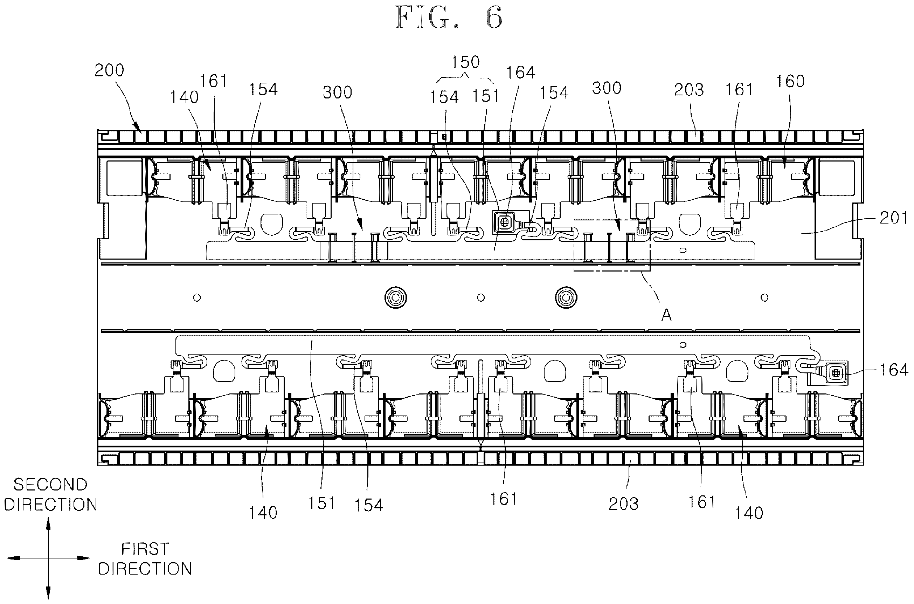

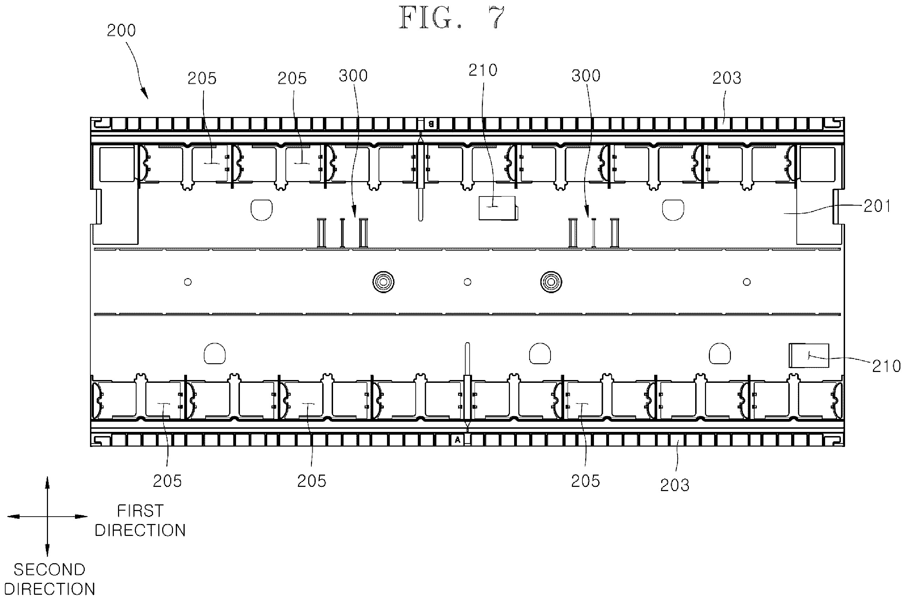

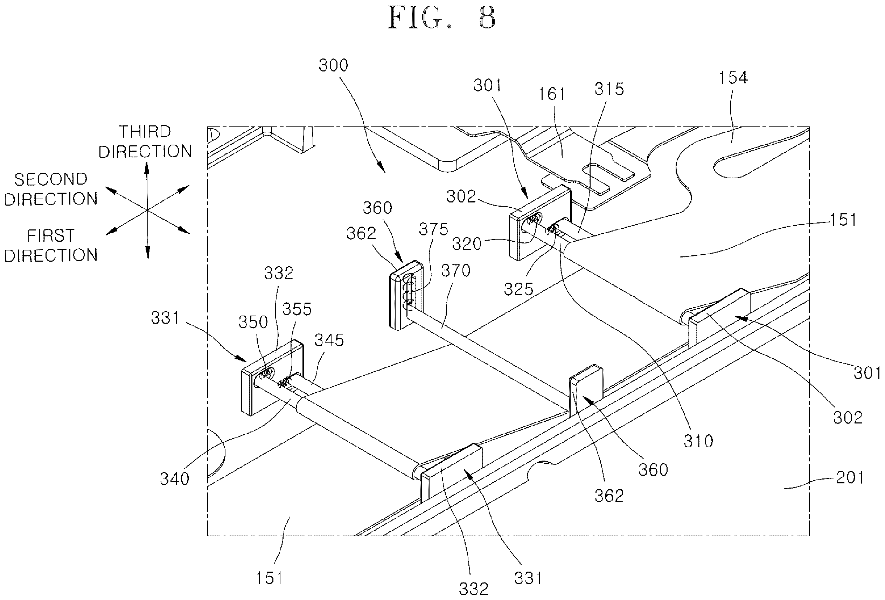

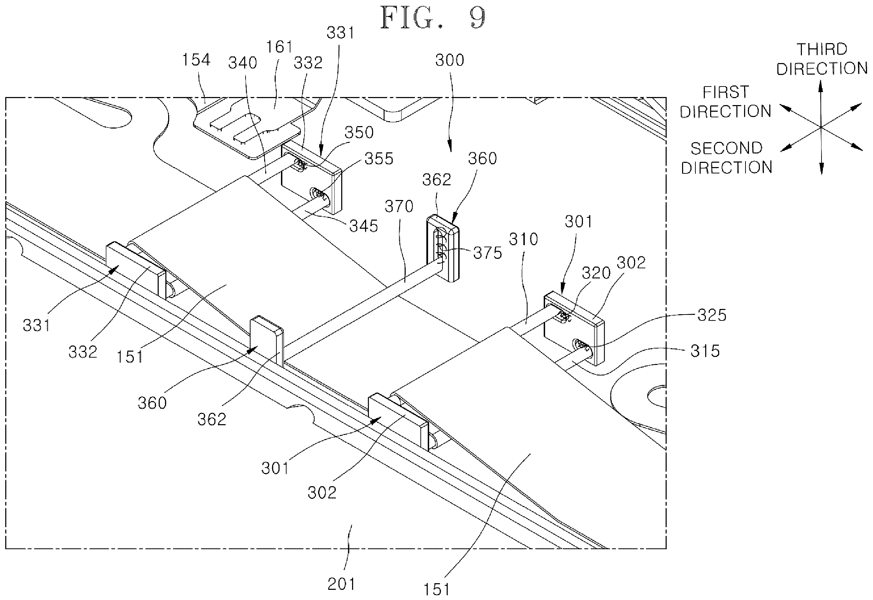

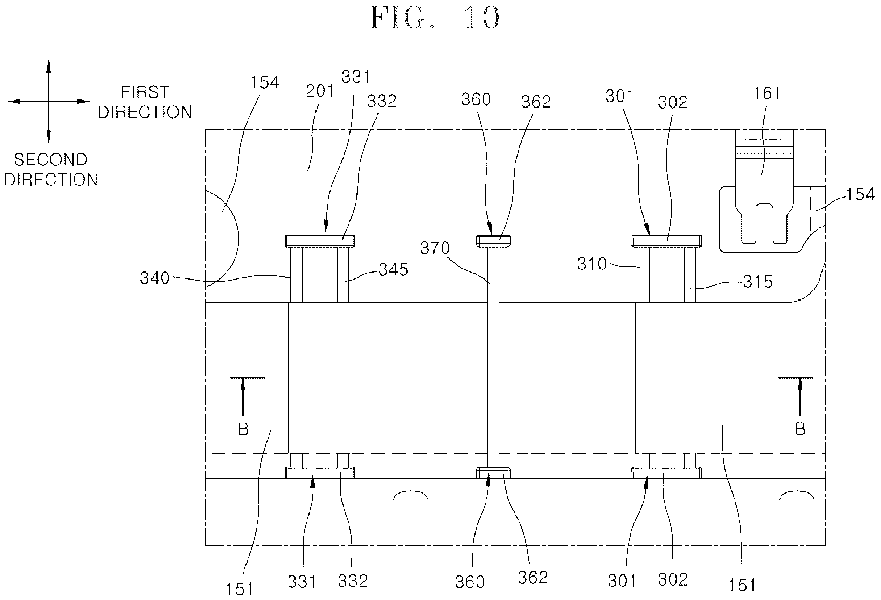

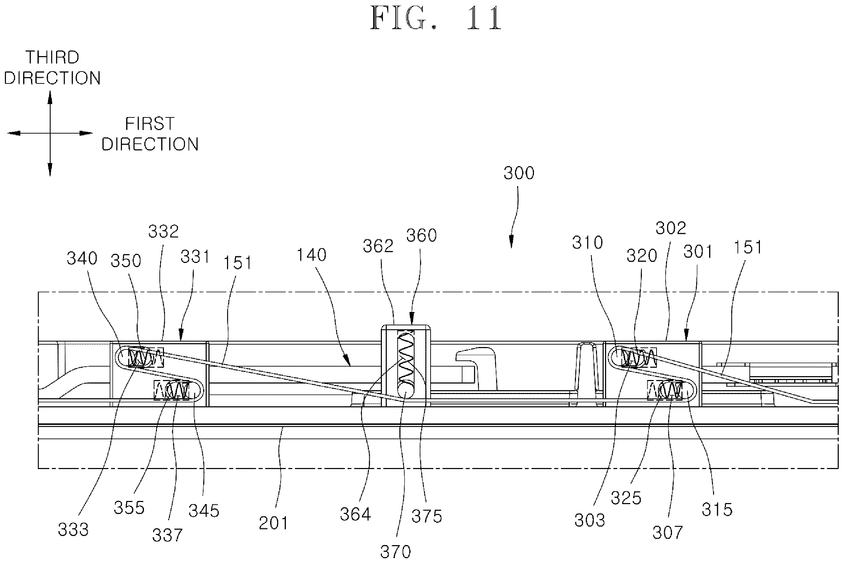

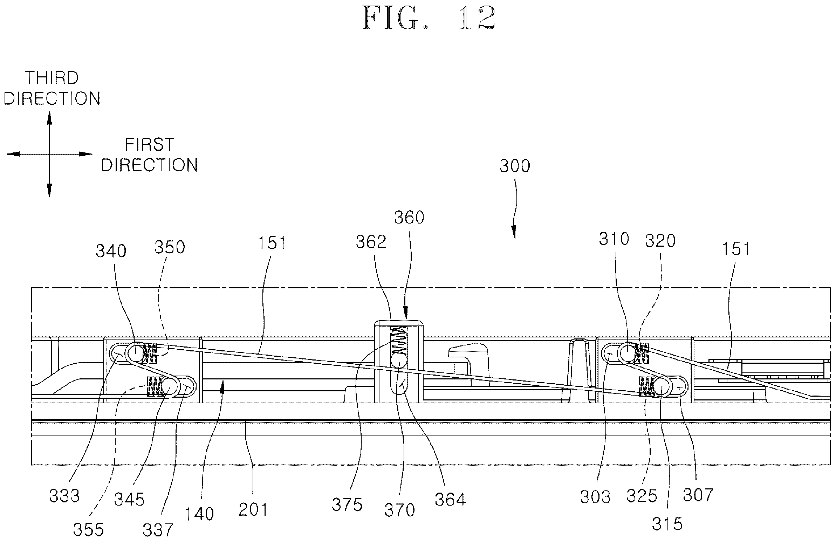

FIG. 1 is a perspective view illustrating a battery module according to an embodiment of the present disclosure; FIG. 2 is a top exploded perspective view illustrating the battery module of FIG. 1; and FIG. 3 is a bottom exploded perspective view illustrating the battery module of FIG. 1. FIG. 4 is a top perspective view illustrating a busbar holder, a busbar, and a flexible printed circuit (FPC) shown in FIG. 2; FIG. 5 is a bottom perspective view illustrating the busbar holder, the busbar, and the FPC shown in FIG. 2; FIG. 6 is a plan view illustrating the busbar holder, the busbar, and the FPC shown in FIG. 2; FIG. 7 is a plan view illustrating the busbar holder shown in FIG. 2; FIG. 8 is an enlarged perspective view illustrating a region "A" of FIG. 6 from a side; FIG. 9 is an enlarged perspective view illustrating the region "A" of FIG. 6 from another side; and FIG. 10 is an enlarged plan view illustrating the region "A" of FIG. 6; FIG. 11 is a cross-sectional view along the line B-B of FIG. 10; and FIG. 12 is a view corresponding to the cross-sectional view of FIG. 11 and illustrating a state in which a plurality of battery cells of the battery module have expanded.

Referring to FIGS. 1 to 3, a battery module 100 according to an embodiment of the present disclosure includes a plurality of battery cells 101, a sensing part, a flexible circuit part 150, and a length adjustment unit, or length adjuster, 300. The sensing part may comprise, or consist of, a sensor or a plurality of sensors, e.g., a voltage sensor 161 and a temperature sensor 164. The battery cells 101 each function as a unit structure which stores and supplies power in the battery module 100. In an embodiment, each of the battery cells 101 may include a cell case 102, a pair of cell terminals 107, and an electrode assembly (not shown).

The electrode assembly may be accommodated in the cell case 102. The electrode assembly may be formed by winding or stacking stacks each including a first electrode plate, a separator, and a second electrode plate, each of which is formed in a thin plate shape or thin membrane shape.

In an embodiment in which the electrode assembly is a wound stack, a winding axis of the electrode assembly may be parallel to a longitudinal direction of the cell case 102. In an embodiment, the electrode assembly may be a stacked type instead of a wound type; however, the present disclosure does not limit a shape of the electrode assembly. In an embodiment, the electrode assembly may be a Z-stack electrode assembly in which a positive electrode plate and a negative electrode plate are inserted between both sides of a separator bent in a Z-stack shape. In an embodiment, one or more electrode assemblies may be stacked and accommodated in the cell case 102 such that long side surfaces thereof are close to each other. A first electrode plate of the electrode assembly may function as a negative electrode, and a second electrode plate may function as a positive electrode. However, the opposite is also possible.

The first electrode plate may be formed by coating a first electric current collector plate, which is formed of a metal foil, such as a copper, copper alloy, nickel, or nickel alloy foil, with a first electrode active material, such as graphite or carbon, and may include a first electrode tab (or first non-coating portion) which is a region which is not coated with the first electrode active material. The first electrode tab may be a path of a current flow between the first electrode plate and a first current collector part. In one or more examples, the first electrode tab may be formed to protrude toward a first side by cutting the first electrode plate when the first electrode plate is manufactured and may protrude toward the first side further than the separator without additional cutting.

The second electrode plate may be formed by coating a second electric current collector plate, which is formed of a metal foil such as an aluminum or aluminum alloy foil, with a second electrode active material, such as a transition metal oxide, and may include a second electrode tab (or second non-coating portion) which is a region which is not coated with the second electrode active material. The second electrode tab may be a path of a current flow between the second electrode plate and a second current collector part. In one or more examples, the second electrode tab may be formed to protrude toward a second side by cutting the second electrode plate when the second electrode plate is manufactured and may protrude toward the second side further than the separator without additional cutting.

In one or more examples, the first electrode tab may be located on a side surface of a left end of the electrode assembly, the second electrode tab may be located on a side surface of a right end of the electrode assembly, or the first electrode tab and the second electrode tab may be located on a surface in a same direction. In this case, the left side and the right side are for convenience of the description; however, a description of the sides may be changed when the battery cell 101 rotates in a left-right or vertical direction.

The first electrode tab of the first electrode plate and the second electrode tab of the second electrode plate are located at end portions of both, or opposite, sides of the electrode assembly. In one or more examples, the electrode assembly may be accommodated in the cell case 102 along with an electrolyte. In an embodiment, in the electrode assembly, the first current collector part and the second current collector part are welded and connected to and located at the first electrode tab of the first electrode plate and the second electrode tab of the second electrode plate, respectively.

In an embodiment, the cell case 102 may have a generally rectangular parallelepiped shape and accommodate the electrode assembly and the electrolyte therein. In an embodiment, the cell case 102 may include a metal case, or can, with an open side and a cap plate for closing the open side of the metal can. In an embodiment, the pair of cell terminals 107 may be installed on the cap plate to protrude outward from the cap plate.

A first cell terminal 107 of the pair of cell terminals 107 may be electrically connected to a current collector part of the first current collector part and the second current collector part, and a second cell terminal 107 may be electrically connected to another current collector part of the first current collector part and the second current collector part. Accordingly, the first cell terminal 107 of the pair of cell terminals 107 may be a positive electrode terminal, and the second cell terminal 107 thereof may be a negative electrode terminal.

The pair of cell terminals 107 may be located at end portions of both, or opposite, sides of the cap plate in a longitudinal direction. A surface of the cell case 102 from which the pair of cell terminals 107 protrude may be an upper surface of the cell case 102, another surface opposite to the upper surface of the cell case 102 may be a lower surface of the cell case 102, and a pair of surfaces which connect the upper surface and the lower surface and are disposed opposite to each other may be a pair of side surfaces of the cell case 102.

In an embodiment, each of the battery cells 101 includes a cell vent 109 which bursts to discharge emissions, such as gas and a flame material (or a flame), from the inside to the outside of the battery cell 101 when a high-temperature gas, the flame material, and the like are generated due to overcharging, abnormal operation, or the like in the cell case 102. The cell vent 109 may be located, for example, in a surface such as the lower surface of the cell case 102 opposite to the surface of the cell case 102 from which the pair of cell terminals 107 protrude.

The plurality of battery cells 101 may be arranged in a line in a first direction. Each of the rear surfaces of a pair of adjacent battery cells 101 among the plurality of battery cells 101 may be disposed to face a front surface of the cell case 102.

For example, the first direction may be a front-rear direction. The cell terminals 107 may each protrude in a third direction perpendicular to the first direction. For example, the third direction may be a vertical direction. A direction perpendicular to the first direction and the third direction may be a second direction. For example, the second direction may be a left-right direction. The second direction may be a width direction of the case 102.

The battery module 100 may further include a pair of end frames 120, a pair of side plates 110, a bottom plate 130, a plurality of busbars 140, a busbar holder 200, a sensing part, and the flexible circuit part 150.

The plurality of battery cells 101 may be interposed between the pair of end frames 120, and the pair of end frames 120 may be disposed to be spaced apart from each other in the first direction. A first end frame 120 of the pair of end frames 120 may be disposed in front of the plurality of battery cells 101 to hide, or cover, a front surface of the cell case 102 located at a frontmost side of a plurality of cell cases 102 arranged in the first direction. A second end frame 120 of the pair of end frames 120 may be disposed behind the plurality of battery cells 101 to hide, or cover, a rear surface of the cell case 102 located at a rearmost side of the plurality of cell cases 102 arranged in the first direction.

The plurality of battery cells 101 may be interposed between the pair of side plates 110, and the pair of side plates 110 may be disposed to be spaced apart from each other in the second direction. The pair of side plates 110 may be disposed to hide, or cover, pairs of side surfaces of the plurality of cell cases 102 and face each other. Front end portions and rear end portions of the pair of side plates 110, that is, end portions of both, or opposite, sides thereof in the first direction, may be connected to end portions of both, or opposite, sides of the pair of end frames 120 in the second direction by, for example, a bonding method, e.g., a method of welding or applying an adhesive.

The plurality of battery cells 101 may be interposed between the bottom plate 130 and the busbar holder 200, and the bottom plate 130 and the busbar holder 200 may be disposed to be spaced apart from each other in the third direction. The bottom plate 130 may be disposed under the plurality of battery cells 101 to hide, or cover, and face lower surfaces of the plurality of cell cases 102. A front end portion and a rear end portion of the bottom plate 130, that is, end portions of both, or opposite, sides thereof in the first direction, may be coupled to the pair of end frames 120.

In an embodiment, the bottom plate 130 may include a plurality of module vents 132 arranged (e.g., arranged one-to-one) with cell vents 109 of the plurality of battery cells 101 in the third direction. The module vents 132 may overlap or cover the cell vents 109. The module vents 132 may be through holes formed to pass through the bottom plate 130 in a thickness direction. A gas discharged from insides to outsides of the cell cases 102 through the cell vents 109 can be quickly discharged to the outside of the battery module 100 through the module vents 132.

The plurality of busbars 140 electrically connect the plurality of battery cells 101. For example, the plurality of busbars 140 may electrically connect a pair of adjacent battery cells 101 among the plurality of battery cells 101. In a pair of battery cells 101 adjacent to each other in the first direction, a positive cell terminal 107 of a battery cell 101 and a negative cell terminal 107 of another battery cell 101 may be connected by the busbar 140. In an embodiment, the busbar 140 and the positive cell terminal 107 or the busbar 140 and the negative cell terminal 107 may be connected by welding.

The busbar holder 200 supports the plurality of busbars 140. The busbar holder 200 may be disposed on the plurality of cell cases 102 to (partially or completely) hide, or cover, upper surfaces of the plurality of cell cases 102. The plurality of busbars 140 and the busbar holder 200 may (partially or completely) hide, or cover, a side of each of the plurality of battery cells 101 in the first direction, and the battery cells 101 include the cell vents 109 at a side opposite to the side hidden, or covered, by the plurality of busbars 140 and the busbar holder 200.

The busbar holder 200 may include a holder plate 201 which supports the plurality of busbars 140. End portions 203 of both, or opposite, sides of the holder plate 201 in the second direction may be coupled to the pair of side plates 110 such that the busbar holder 200 may be supported by the pair of side plates 110.

Referring to FIGS. 4 to 12, the busbar holder 200 includes a plurality of cell terminal through holes 205 formed to pass through the holder plate 201 (or formed in the holder plate 201) in a thickness direction thereof such that the plurality of cell terminals 107 protruding from the plurality of battery cells 101 pass through the plurality of cell terminal through holes 205. The busbars 140 may be connected to the cell terminals 107 which pass through and protrude from the cell terminal through holes 205.

The sensing part measures a state of the plurality of battery cells 101. In an embodiment, the sensing part may include a plurality of voltage sensors 161 and a plurality of temperature sensors 164. The plurality of voltage sensors 161 may measure voltages of the plurality of battery cells 101. In an embodiment, each of the voltage sensors 161 may be electrically connected to one of the busbars 140 by welding.

The plurality of temperature sensors 164 may measure temperatures of the plurality of battery cells 101. The busbar holder 200 may include a plurality of temperature sensor through portions 210 provided for the plurality of temperature sensors 164 to pass through the holder plate 201. The temperature sensor through portions 210 may include through holes formed to pass through the holder plate 201 (or formed in the through holder plate 201) in the thickness direction.

In an embodiment, the plurality of temperature sensor through portions 210 may be provided as a pair of temperature sensor through portions 210, and the temperature sensors 164 may be provided as a pair of temperature sensors 164 to correspond one-to-one to the temperature sensor through portions 210. In an embodiment, one of the pair of temperature sensor through portions 210 may be located to be biased to a first side of the holder plate 201 in the first direction, and the other may be located in a central portion of the holder plate 201 in the first direction. The pair of temperature sensors 164 may pass through the holder plate 201 through the pair of temperature sensor through portions 210 and may be attached to the cell cases 102 by, for example, an adhesive member, such as a double-sided adhesive tape.

The flexible circuit part 150 transmits electric signals generated by the voltage sensors 161 and the temperature sensors 164 of the sensing part to a controller (not shown) which controls the operation of the battery module 100. The flexible circuit part 150 may include the FPC.

The flexible circuit part 150 may be provided as a pair of flexible circuit parts 150. One flexible circuit part 150 of the pair of flexible circuit parts 150 may be located closer to the plurality of busbars 140 arranged in a line at a side in the second direction, and the other flexible circuit part 150 may be located closer to the plurality of busbars 140 arranged in a line at another side in the second direction.

The pair of flexible circuit parts 150 may each include a main circuit part 151 and a plurality of sub-circuit parts 154. In an embodiment, the main circuit part 151 may extend to be parallel to the first direction which is an arrangement direction of the plurality of battery cells 101.

The sub-circuit parts 154 may connect the sensing part and the main circuit part 151. The sub-circuit parts 154 may be provided as a plurality of sub-circuit parts 154. In an embodiment, some of the plurality of sub-circuit parts 154 electrically connect the plurality of voltage sensors 161 and a corner of the main circuit part 151, and the other of the plurality of sub-circuit parts 154 may electrically connect the temperature sensors 164 and a corner (or an edge) of the main circuit part 151.

In an embodiment, the sub-circuit parts 154 may each have a smaller width than the main circuit part 151 in the second direction. In an embodiment, the sub-circuit part 154 may extend along a curved path, for example, along an S-shaped path or an U-shaped path. In an embodiment, if the voltage sensor 161 or the temperature sensor 164 is finely position-changed while the battery module 100 is charged or discharged, since the sub-circuit part 154 is changed to correspond to the position change of the voltage sensor 161 or the temperature sensor 164, disconnection between the voltage sensor 161 and the flexible circuit part 150 or disconnection between the temperature sensor 164 and the flexible circuit part 150 may not occur. The flexible circuit part 150 may compensate for a difference in the positions of the voltage sensor 161 and/or the temperature sensor 164 occurring due to expansion of one or more battery cells 101.

The length adjustment unit 300 supports the flexible circuit parts 150 such that the flexible circuit part 150 extends along a bent path. For example, the length adjustment unit 300 may support the main circuit part 151. The length adjustment unit 300 may support the main circuit part 151 between a pair of voltage sensors 161 spaced apart from each other among the plurality of voltage sensors 161.

The length adjustment unit 300 may include, or be disposed as, a plurality of length adjustment units 300 in some or each of the flexible circuit parts 150 to be spaced apart from each other. However, in an embodiment, one length adjustment unit 300 may be disposed in each flexible circuit part 150, unlike those shown in FIGS. 4 to 6.

The plurality of length adjustment units 300 may be included in the busbar holder 200. The plurality of length adjustment units 300 may be supported by the holder plate 201. In an embodiment, each of the length adjustment units 300 may include a first bent path part (or section) 301, a second bent path part (or section) 331, and a tension adjustment part, or tension adjuster, 360.

However, a length adjustment unit according to another embodiment of the present disclosure may not be included in a busbar holder, unlike those shown in FIGS. 4 to 12. For example, a battery module may further include a module cover supported by the busbar holder, and the length adjustment unit may be supported by the module cover.

The first bent path part 301 and the second bent path part 331 may be disposed to be spaced apart from each other in a longitudinal direction of the main circuit part 151. In an embodiment, the tension adjustment part 360 may be disposed between a pair of bent path parts 301 and 331 spaced apart from each other.

In an embodiment, the first bent path part 301 may include a first roller 310, a second roller 315, a first roller bracket 302, a first elastic member 320, and a second elastic member 325. The first roller 310 and the second roller 315 are disposed to support the main circuit part 151 and spaced apart from each other such that the main circuit part 151 extends along a zigzag path. The first roller 310 and the second roller 315 may extend in the second direction perpendicular to the first direction which is the longitudinal direction of the main circuit part 151. A length of the main circuit part 151 in the first direction may be greater than a length of a space covered by the main circuit part 151. The main circuit part 151 may comprise a folded section.

The first roller bracket 302 supports the first roller 310 and the second roller 315. The first roller bracket 302 may include, or be provided as, a pair of first roller brackets 302 to support end portions of both sides of the first roller 310 and the second roller 315 in a longitudinal direction. The pair of first roller brackets 302 may be fixedly supported by the holder plate 201.

The first roller 310 and the second roller 315 may be supported by the first roller brackets 302 to allow the first roller 310 and the second roller 315 to be position-moved (or moved, or moved such, that a position of the second roller is changed) in the first direction. A first roller long groove 303, which may be a groove supporting an end of the first roller 310 in the first direction, into which an end portion of the first roller 310 in the longitudinal direction is fitted to be moved in the first direction and a second roller long groove 307, which may be a groove supporting an end of the second roller 315 in the first direction, into which an end portion of the second roller 315 in the longitudinal direction is fitted to be moved in the first direction may be formed in the first roller bracket 302. The first roller long groove 303 and the second roller long groove 307 may be provided at different levels (e.g., different heights) such that the first roller 310 and the second roller 315 are disposed at different levels in the third direction.

The first elastic member 320 elastically presses the first roller 310 in a direction in which the first roller 310 is moved away from the second roller 315. For example, the first elastic member 320 may be a coil spring, an elastomer element, or the like. The first elastic member 320 may be installed in the first roller bracket 302 to be fitted into the first roller long groove 303.

The second elastic member 325 elastically presses the second roller 315 in a direction in which the second roller 315 is moved away from the first roller 310. For example, the second elastic member 325 may be a coil spring, an elastomer element, or the like. The second elastic member 325 may be installed in the first roller bracket 302 to be fitted into the second roller long groove 307.

The first elastic member 320 and the second elastic member 325 may be provided as a pair of first elastic members 320 and a pair of second elastic members 325 to correspond to the pair of first roller brackets 302. A length adjustment unit, or length adjuster, included in another embodiment may include a second roller which is not position-moved (or not moved) in a first direction and may not include an elastic member which elastically presses the second roller, unlike the embodiment of the present disclosure illustrated in FIG. 8 to 12. In addition, in the length adjustment unit 300 included in the embodiment of the present disclosure illustrated in FIGS. 8 to 12, the first roller 310 is located at a level higher than that of the second roller 315 in the third direction. However, in a length adjustment unit included in another embodiment of the present disclosure, a first roller may be located at a level lower than that of a second roller in a third direction, unlike the length adjustment unit 300.

In an embodiment, the second bent path part 331 may include a first roller 340, a second roller 345, a second roller bracket 332, a first elastic member 350, and a second elastic member 355. The first roller 340 and the second roller 345 may be disposed to support the main circuit part 151 and spaced apart from each other such that the main circuit part 151 extends along a zigzag path. The first roller 340 and the second roller 345 may extend in the second direction perpendicular to the first direction which is the longitudinal direction of the main circuit part 151.

The second roller bracket 332 supports the first roller 340 and the second roller 345. The second roller bracket 332 may be provided as a pair of second roller brackets 332 to support end portions of both, or opposite, sides of the first roller 340 and the second roller 345 in a longitudinal direction. The pair of second roller brackets 332 may be fixedly supported by the holder plate 201.

The first roller 340 and the second roller 345 may be supported by the second roller brackets 332 to allow the first roller 340 and the second roller 345 to be position-moved (or moved) in the first direction. A first roller long groove 333 into which an end portion of the first roller 340 in the longitudinal direction is fitted to be moved in the first direction and a second roller long groove 337 into which the end portion of the second roller 345 in the longitudinal direction is fitted to be moved in the first direction may be formed in the second roller bracket 332. In an embodiment, the first roller long groove 333 and the second roller long groove 337 may be provided at different levels such that the first roller 340 and the second roller 345 are disposed at different levels (or heights) in the third direction.

The first elastic member 350 elastically presses the first roller 340 in a direction in which the first roller 340 is moved away from the second roller 345. For example, the first elastic member 350 may be a coil spring, an elastomer member or the like. The first elastic member 350 may be installed in the second roller bracket 332 to be fitted into the first roller long groove 333.

The second elastic member 355 elastically presses the second roller 345 in a direction in which the second roller 345 is moved away from the first roller 340. For example, the second elastic member 355 may be a coil spring. The second elastic member 355 may be installed in the second roller bracket 332 to be fitted into the second roller long groove 337.

The first elastic member 350 and the second elastic member 355 may be provided as a pair of first elastic members 350 and a pair of second elastic members 355 to correspond to the pair of second roller brackets 332. A length adjustment unit included in another embodiment of the present disclosure may include a second roller which is not position-moved (or moved) in a first direction and may not include an elastic member which elastically presses the second roller, unlike the embodiment of the present disclosure illustrated in FIG. 8 to 12. In addition, in the length adjustment unit 300 included in the embodiment of the present disclosure illustrated in FIGS. 8 to 12, the first roller 340 is located at a level (or height) higher than that of the second roller 345 in the third direction. However, in a length adjustment unit included in another embodiment of the present disclosure, a first roller may be located at a level (or height) lower than that of a second roller in a third direction, unlike the length adjustment unit 300.

The tension adjustment part 360 may include a tension roller 370, a tension roller bracket 362, and an elastic tension roller pressing member 375. The tension roller 370 may be in contact with the main circuit part 151 and may be moved by tension of the main circuit part 151. The tension roller 370 may extend in the second direction perpendicular to the first direction which is the longitudinal direction of the main circuit part 151.

The tension roller bracket 362 supports the tension roller 370. In an embodiment, the tension roller bracket 362 may be provided as a pair of tension roller brackets 362 to support end portions of both, or opposite, sides of the tension roller 370 in a longitudinal direction. The pair of tension roller brackets 362 may be fixedly supported by the holder plate 201.

The tension roller 370 may be supported by the tension roller brackets 362 to allow the tension roller 370 to be position-moved (or moved) in the third direction intersecting the first direction in which the first rollers 310 and 340 and the second rollers 315 and 345 move (or are movable). In an embodiment, a tension roller long groove 364 into which an end portion of the tension roller 370 in the longitudinal direction is fitted to be moved in the third direction may be formed in the tension roller bracket 362.

The elastic tension roller pressing member 375 elastically presses the tension roller 370 in an increase direction of the tension of the main circuit part 151 (for example, a direction in which the tension of the main circuit part 151 increases when the tension roller 370 is moved in said direction). In the embodiment of the present disclosure illustrated in FIG. 8, the main circuit part 151 passes under the tension roller 370, and the elastic tension roller pressing member 375 elastically presses the tension roller 370 downward. However, in another embodiment of the present disclosure, a main circuit part 151 may pass over a tension roller 370, and an elastic tension roller pressing member 375 may elastically press the tension roller 370 upward.

For example, the elastic tension roller pressing member 375 may be a coil spring, an elastomer element or the like. The elastic tension roller pressing member 375 may be installed in the tension roller bracket 362 to be fitted into the tension roller long groove 364. In an embodiment, the elastic tension roller pressing member 375 may be provided as a pair of elastic tension roller pressing members 375 to correspond to the pair of tension roller brackets 362.

The cell case 102 of the battery cell 101 may expand while the battery module 100 is charged or discharged, and, thus, the voltage sensor 161 and the temperature sensor 164 may be position-changed (or moved) in the first direction. When the sensors 161 and 164 are position-changed (or moved), stress increases at portions at which the sensors 161 and 164 are connected to the flexible circuit part 150, and, thus, the sensors 161 and 164 may be electrically disconnected from the flexible circuit part 150, for example, when the battery module 100 does not comprise the length adjustment unit 300.

Although the portions at which the sensors 161 and 164 are connected to the flexible circuit part 150 may not be damaged, tension of the flexible circuit part 150 may excessively increase, and, thus, a circuit provided in the flexible circuit part 150 may be disconnected.

The length adjustment unit 300 supports the main circuit part 151 such that a length of a section bent along a zigzag path decreases when a volume of the battery cell 101 expands and tension of the main circuit part 151 increases. The tension of the main circuit part 151 increased due to the expansion of the battery cell 101 pushes the first rollers 310 and 340, the second rollers 315 and 345, and the tension roller 370 to elastically compress the first elastic members 320 and 350, the second elastic members 325 and 355, and the elastic tension roller pressing member 375. Accordingly, a length of a bent section of the main circuit part 151 may decrease, and the tension of the main circuit part 151 may be relieved. As a result, the portions at which the sensors 161 and 164 are connected to the flexible circuit part 150 are not damaged, and the circuit provided in the flexible circuit part 150 is not disconnected.

When the battery cell 101 expands while the battery module 100 is charged or discharged, the sensors 161 and 164 may be position-changed (or moved) in the second direction. In this case, since the sub-circuit part 154 which extends along the bent path and has the smaller width than the main circuit part 151 is elastically deformed in a direction in which it is spread in the second direction and to follow position changes of the sensors 161 and 164, disconnection of the portions at which the sensors 161 and 164 are connected to the flexible circuit part 150 or the circuit provided in the flexible circuit part 150 can be more reliably prevented.

According to one or more embodiments of the present disclosure, a length adjustment unit supports a flexible circuit part such that a bent portion is formed in the flexible circuit part, the length adjustment unit is deformed to decrease a length of the bent portion of the flexible circuit part when the battery cell expands, and an original form of the length adjustment unit is restored when the battery cell contracts to an original volume thereof. Accordingly, even if the battery cell expands significantly, the flexible circuit part is not disconnected from a sensing part, or the flexible circuit part is not damaged, and, thus, the durability of the battery module can be improved.

However, aspects and features of the present invention are not limited to those described above and other aspects and features not mentioned will be clearly understood by those skilled in the art from the detailed description provided above.

Although the present invention has been described with reference to some embodiments and drawings illustrating some aspects thereof, the present invention is not limited thereto. Various modifications and variations can be made by a person skilled in the art to which the present invention belongs within the scope of the invention and the claims.

## Claims

1. A busbar holder (200) comprising:
a holder plate (201) which supports a plurality of busbars (140) electrically connecting a plurality of battery cells (101); and
a length adjuster (300) supported by the holder plate (201) and supporting a flexible circuit part (150) configured to transmit an electric signal generated by measuring a state of the battery cells (101) such that the flexible circuit part (150) extends along a bent path.

2. The busbar holder (200) as claimed in claim 1, wherein the length adjuster (300) supports the flexible circuit part (150) such that a length of a bent section of the flexible circuit part (150) decreases when a volume of the battery cells (101) increases.

3. The busbar holder (200) as claimed in claim 1 or claim 2, wherein the length adjuster (300) comprises a bent path part (301) comprising:
a first roller (310) and a second roller (315) arranged to support the flexible circuit part (150) and spaced apart from each other such that the flexible circuit part (150) extends along a zigzag path; and
a first elastic member (320) which elastically presses the first roller (310) in a direction in which the first roller (310) is moved away from the second roller (315).

4. The busbar holder (200) as claimed in claim 3, wherein
the bent path part comprises a plurality of bent path parts, and
the length adjuster further comprises a tension adjuster (360) comprising a tension roller (370) which is located between a pair of bent path parts (301, 331) spaced apart from each other among the plurality of bent path parts, is in contact with the flexible circuit part (150), and is movable by tension of the flexible circuit part (150).

5. The busbar holder (200) as claimed in claim 4, wherein the tension adjuster (360) further comprises:
a tension roller bracket (362) which supports the tension roller (370) to allow the tension roller (370) to be position-moved; and
an elastic tension roller pressing member (375) which elastically presses the tension roller (370) in an increase direction of the tension of the flexible circuit part (150).

6. The busbar holder (200) as claimed in one of claims 1 to 5, further comprising a temperature sensor through portion (210) for a temperature sensor (164) to measure a temperature of the plurality of battery cells (101) to pass through the holder plate (201).

7. A battery module (100) comprising:
a plurality of battery cells (101);
a sensing part to measure a state of the battery cells (101);
a flexible circuit part (150) to transmit an electric signal generated by the sensing part; and
a length adjuster (300) which supports the flexible circuit part (150) such that the flexible circuit part (150) extends along a bent path.

8. The battery module (100) as claimed in claim 7, wherein the length adjuster (300) supports the flexible circuit part (150) such that a length of a bent section of the flexible circuit part (150) decreases when a volume of the battery cells (101) increases.

9. The battery module (100) as claimed in claim 7 or claim 8, wherein the length adjuster (300) comprises a bent path part comprising:
a first roller (310) and a second roller (315) arranged to support the flexible circuit part (150) and spaced apart from each other such that the flexible circuit part (150) extends along a zigzag path; and
a first elastic member (320) which elastically presses the first roller (310) in a direction in which the first roller (310) is moved away from the second roller (315).

10. The battery module (100) as claimed in claim 9, wherein the bent path part further comprises a roller bracket (302) which supports the first roller (310) to allow the first roller (310) to be position-moved.

11. The battery module (100) as claimed in claim 10, wherein
the bent path part further comprises a second elastic member (325) elastically supporting the second roller (315) in a direction in which the second roller (315) is movable away from the first roller (310), and
the roller bracket (302) supports the second roller (315) to allow the second roller (315) to be position-moved.

12. The battery module (100) as claimed in claim 9, wherein
the bent path part comprises a plurality of bent path parts, and
the length adjuster (300) further comprises a tension adjuster (360) comprising a tension roller (370) which is located between a pair of bent path parts (301, 331) spaced apart from each other among the plurality of bent path parts, is in contact with the flexible circuit part (150), and is movable by tension of the flexible circuit part (150).

13. The battery module (100) as claimed in claim 12, wherein the tension adjuster (360) further comprises:
a tension roller bracket (362) which supports the tension roller (370) to allow the tension roller (370) to be position-moved; and
an elastic tension roller pressing member (375) which elastically presses the tension roller (370) in an increase direction of the tension of the flexible circuit part (150).

14. The battery module (100) as claimed in one of claims 7 to 13, wherein
the plurality of battery cells (101) are arranged in an arrangement direction,
the flexible circuit part (150) comprises a main circuit part (151) extending to be parallel to the arrangement direction of the plurality of battery cells (101), and a sub-circuit part (154) connecting the sensing part and the main circuit part (151), and
the length adjuster supports the main circuit part (151).

15. The battery module (100) as claimed in one of claims 7 to 14, further comprising:
a plurality of busbars (140) electrically connecting the plurality of battery cells (101); and
a busbar holder (200) supporting the plurality of busbars (140),
wherein the busbar holder (200) comprises the length adjuster (300).
